(19)

Europäisches
Patentamt
European
Patent Office
Office européen
des brevets

(11) **EP 1 821 415 B1**

(12) **EUROPEAN PATENT SPECIFICATION**

(45) Date of publication and mention
of the grant of the patent:
**11.03.2009 Bulletin 2009/11**

(51) Int Cl.:
**H03M 13/29** (2006.01)    H03M 13/45 (2006.01)

(21) Application number: **06003196.0**

(22) Date of filing: **16.02.2006**

(54) **Hybrid decoding using multiple turbo decoders in parallel**

Hybride Dekodierung unter Benutzung mehrerer paralleler Turbo-Dekoder

Décodage hybride comprenant plusieurs turbo décodeurs en parallèle

(84) Designated Contracting States:
**AT BE BG CH CY CZ DE DK EE ES FI FR GB GR
HU IE IS IT LI LT LU LV MC NL PL PT RO SE SI
SK TR**

(43) Date of publication of application:
**22.08.2007 Bulletin 2007/34**

(73) Proprietor: **Telefonaktiebolaget L M Ericsson
(Publ)
164 83 Stockholm (SE)**

(72) Inventor: **Wang, Xiaohui
247 35 Södra Sandby (SE)**

(74) Representative: **Bratt, Hanna Catharina et al
Ericsson AB
Patent Unit Mobile Platforms
221 83 Lund (SE)**

(56) References cited:
**EP-A- 1 083 660          US-A1- 2002 040 461
US-A1- 2004 151 259      US-A1- 2005 210 358
US-B1- 6 400 731          US-B2- 6 799 295**

- **FOSSORIER M P C ET AL: "Complementary
reliability-based decodings of binary linear block
codes" IEEE TRANSACTIONS ON INFORMATION
THEORY, IEEE SERVICE CENTER,
PISCATAWAY, NJ, US, vol. 43, no. 5, September
1997 (1997-09), pages 1667-1672, XP002264082
ISSN: 0018-9448**

EP 1 821 415 B1

**Description**

Technical field

The present invention relates to error handling in the field of communication systems, and more specifically to decoding signals, which have been transmitted using error correction codes, using a Turbo decoding technique.

Background art

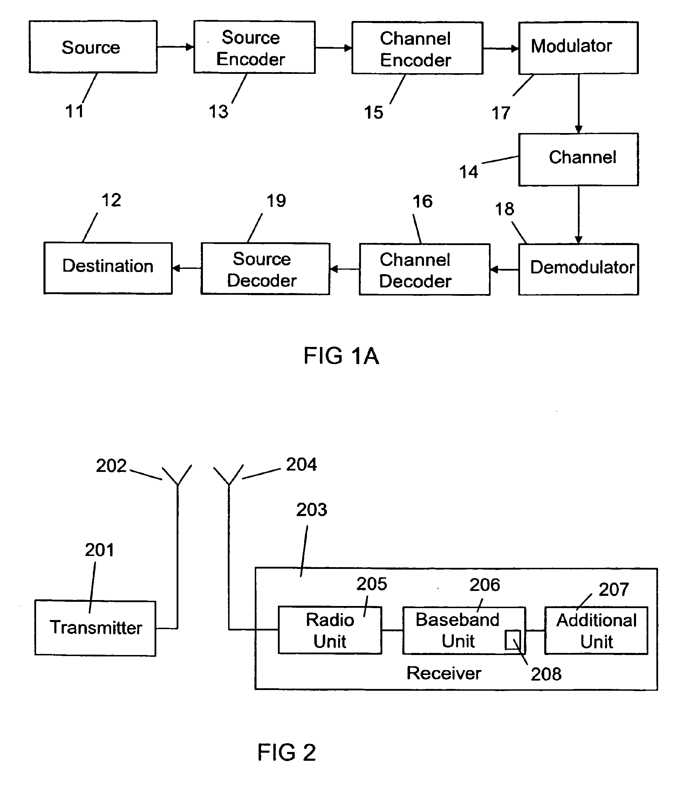

In communication systems, a signal representing information is sent from a transmitter to a receiver via a channel. Most modern radio communication systems operate in the digital domain, which involves a number of different signal processing possibilities. Fig 1A schematically shows such a communication system. A source 11 generates information which is to be sent to a destination 12. The information may be analog or digital, depending on the source. As an example, voice transmitted during a telephone conversation is represented by an analog signal generated by the microphone. The speaker and the microphone together form an analog source. When an analog signal is to be transmitted over a digital communication system, it is converted into a digital signal, consisting of a stream of bits, by a source encoder 13. The source encoder 13 tries to represent the signal from the source by as few bits as possible. This process is called data compressing. When the source is digital, the source encoder 13 still performs data compression by i.e. reducing the amount of redundant information in the signal from the source 11.

In cases when it is expected that the channel 14 will distort the signal (which is usually the case in radio communication systems), a channel encoder 15 may be employed to lessen this effect. Channel encoding involves encoding the information in such a way prior to transmission that, when the complementary channel decoding process is performed in a channel decoder 16 at the receiver, it will be possible to correct and/or detect errors in the received signal.

Channel encoding typically involves generating one or more extra bits as a function of the input information bitstream, or, in other words, channel encoding adds redundancy in a structured manner to the bitstream. The extra bits are transmitted along with the original information bits and are used in the channel decoding process to correct and/or detect errors in the received bits.

After the channel encoding, a modulator 17 is used to convert the bitstream into waveforms suitable for transmission over the channel 14. After transmission over the channel 14, the signal is demodulated by a demodulator 18, which performs a conversion of the waveforms into a bitstream. Since the channel 14 introduces noise and interference, the signal output from the demodulator 18 normally is different from the signal input to the modulator 17.

The output bitstream from the demodulator is input to the channel decoder, and, finally, the source decoder 19 outputs the signal to the destination 12.

Returning to the channel coding process, one technique that is known in the art is called Turbo coding. Turbo coding arrangements and operation are described in many publications, of which C. Berrou and A. Glavieux, "Near Optimum Error Correcting Coding and Decoding: Turbo-codes," IEEE Transactions on Communications, 44(10), October 1996 is one example.

Turbo coders are being designed into more and more systems. For example, the third generation partnership project, 3GPP, has chosen Turbo coding as one of the methods for channel coding in WCDMA (Wideband Code Division Multiple Access) mobile communication systems.

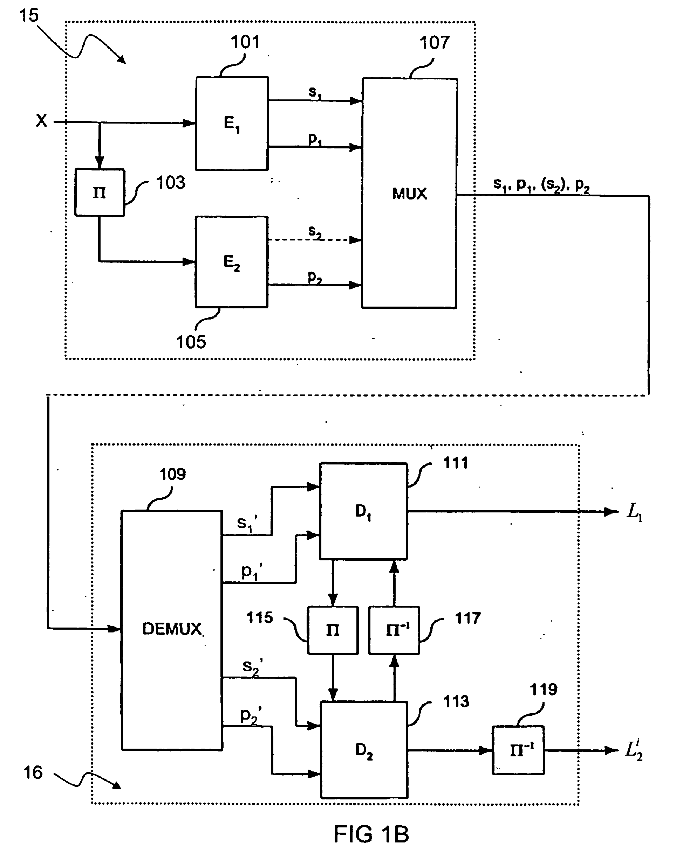

FIG. 1B is a block diagram of the channel encoding 15 and decoding 16 parts of a communication system that employs a classic Turbo encoder/decoder arrangement. On the transmitter side, an information bitstream, X, is supplied to a first encoder 101 and also to an interleaver 103. The interleaver 103 shuffles the information bitstream, X, and supplies the shuffled bits to a second encoder 105. The first encoder 101 generates a first stream of systematic bits, $s_1$, and a first stream of parity bits, $p_1$. The systematic bits, $s_1$, represent the original information supplied to the first encoder 101, whereas the parity bits, $p_1$, represent the redundant information generated by the first encoder 101.

The second encoder 105 similarly generates a second stream of systematic bits, $s_2$, and a second stream of parity bits, $p_2$. The systematic bits, $s_2$, represent the original shuffled information bits supplied to the second encoder 105, and the parity bits, $p_2$, represent the redundant information generated by the second encoder 105.

The outputs from the first encoder 101 and the second encoder 105 are supplied to a multiplexer 107, which combines them into a single bitstream that is to be transmitted to the receiver via a channel. It will be recognized that, since the systematic bits $s_2$ merely represent a shuffled version of the systematic bits $s_1$, it is not really necessary to transmit the systematic bits $s_2$ to the receiver. This is represented in the figure by the use of dashed lines and parentheses. In embodiments in which only $s_1$, $p_1$ and $p_2$ are transmitted, the receiver side would include circuitry (not shown) for re-creating $s_2$ by suitably shuffling the received version of $s_1$. For the sake of simplicity, the figure is drawn as though $s_2$ were transmitted along with the other parameters $s_1$, $p_1$ and $p_2$. The dashed line between the encoding part and the decoding part is meant to indicate that the bitstream is transmitted over a channel using various units such as is well known in the art.

At the receiver, the bit stream sent over the channel is estimated and represented in the form of soft parameter values or soft bits $s_1'$, $p_1'$, $s_2'$ and $p_2'$. These values are supplied from a demultiplexer 109 that also splits them up into their constituent parts and supplies these parts in pairs to a respective one of a first maximum a posteriori (MAP) decoder 111 and a second MAP decoder 113. The first MAP decoder 111 operates on the non-interleaved bits $s_1'$, $p_1'$, and the second MAP decoder 113 operates on the interleaved bits $s_2'$, $p_2'$.

Typically, the decoding process starts with one run of the first decoder 111, which generates extrinsic information as well as an output vector $L_1$. In the terminology of Turbo decoders, this procedure is called one half iteration. The extrinsic information is in the form of soft values, or estimates of the original transmitted data symbols, whereas the output vector $L_1$ consists of hard values (i.e., the decided upon values that are considered to represent the original transmitted data symbols).

In the Turbo decoder arrangement, the extrinsic information generated by the first decoder 111 as a result of its half iteration is shuffled by an interleaver 115, and the shuffled information is then supplied to the second decoder 113. The second decoder 113 is then permitted to operate. The extrinsic information supplied by the first decoder 111 via the interleaver 115 is taken into account when the second decoder 113 performs its half iteration, which in turn produces extrinsic information as well as an output vector that, after un-shuffling by the deinterleaver 119, is an output vector $L^i_2$. Since the second decoder 113 operates on interleaved data, its outputs are also interleaved. Thus, the extrinsic information generated by the second decoder 113 is supplied to a deinterleaver 117 so that it may be passed on to the first decoder 111 for use in a next half iteration.

In operation, some number of Turbo decoder iterations are performed until the output vector $L^i_2$ is considered to have converged on a reliable result.

Theoretically, the MAP decoder mentioned above is an optimal decoder. Since it involves complicated multiplication and exponentiation operations, its equivalent in the logarithmic domain, the logarithmic maximum a posteriori decoder (Log-MAP) is often implemented instead, which replaces the multiplications by additions. However, the Log-MAP decoder is still too computationally intensive for many applications, e.g. in handsets for mobile telephony, and therefore a decoder approximation which is denoted Log-Max (logarithmic maximum) is implemented for some cases. Experience has shown that the performance of Log-Max is worse than that of Log-MAP for good transmission conditions, but for heavily fading or noisy channels Log-Max can perform better than Log-MAP.

In US2004/0151259 A1, a method of decoding a Turbo-code encoded signal is described wherein, in a first variant, an error information representing an error of the SIR (Signal to Interference Ratio) is determined and compared to a threshold value to decide whether the channel conditions are good or bad. In the former case, a Log-MAP algorithm is selected and in the latter case a "MaxLogMAP" (in this application called Log-Max) algorithm is selected. In a second variant the speed of a mobile phone as well as a delay profile for the transmission channel are used for deciding which algorithm to use.

It may be noted that the selection methods according to US2004/0151259 A1 depend heavily on the accuracy and timing of the estimates of SIR or the instantaneous delay profiles for various speeds. All of these may be difficult to estimate properly in a radio environment with fading and varying speeds. Moreover, in US2004/0151259 the performance of the Turbo decoders have been measured statistically, which means that for an arbitrary coding block it is uncertain which decoder will give the best result.

US 6 400 731 discloses a variable rate CDMA communication system in which the receiver comprises a plurality of Viterbi decoders that are operated in parallell.

Fossorier M. P. C et al "Complementary reliability-based decodings of binary linear block codes" in IEEE Transactions on information theory, IEEE Service center, Piscataway, NJ, US, vol. 43, no. 5, September 1997 (1997-09), pages 1667-1672, xP002264082 discloses a hybrid reliability-based decoding algorithm which combines the reprocessing method based on the most reliable basis and a generalized Chase-type algebraic decoder based on the least reliable positions.

US 2002/0404 discloses Log-MAP and Max-Log-MAP decoding algorithms for Turbo decoding.

Thus, it is desirable to provide strategies for selecting decoder algorithms for a Turbo decoder arrangement.

<u>Summary</u>

A purpose of the embodiments of the present invention is to provide methods and receivers that Turbo decode Turbo encoded information and alleviate the foregoing and other problems.

According to an aspect of the invention, such a method for Turbo decoding a received Turbo encoded bitstream in a communication system is disclosed. The method comprises the steps of decoding the received bitstream using a first Turbo decoding algorithm to produce a first decoded bitstream and a first error measure, in parallel with decoding the received bitstream using a second Turbo decoding algorithm for producing a second decoded bitstream and a second error measure, and selecting, for further processing in a receiver, the decoded bitstream and error measure from the decoding algorithm which produces the most favorable error measure.

Specifically, at least two different Turbo decoders are run in parallel and the output from the decoder is selected which gives the best result according to some given criteria, under the existing circumstances.

This gives the possibility to choose the best available decoding algorithm on the level of each single coding block, unaffected by statistical measurement latencies and errors.

It should be noted that a lot of processing power is consumed by, for example, a radio unit and a baseband unit in the receiver prior to decoding, and, therefore, it is important that the channel decoder does not fail to deliver the correct results. Since embodiments of the invention improve the performance of the receiver by using only the output from the decoder which is most suited for the present conditions, this is much less likely to happen. Further, this makes it possible to save the transmitting power of the transmitter.

Thus, embodiments of the present invention provide an efficient way of performing channel decoding.

According to embodiments of the invention, the error measure corresponds to the number of error indicating Cyclic Redundancy Check (CRC) flags.

In the decoding step, the first error measure can be determined on basis of the number of error indicating CRC flags associated with the first decoded bitstream and the second error measure can be determined on basis of the number of error indicating CRC flags associated with the second decoded bitstream. In the selecting step, the most favorable error measure can be the error measure corresponding to the smallest number of error indicating CRC flags. In other words, if only one CRC flag is used for determining the error measure, the decoder output having a CRC flag indicating no error is chosen. If the number of CRC flags used for determining the error measure is larger than one, the decoder output, which comprises the smallest number of error indicating CRC flags and, thus, the smallest number of incorrectly decoded blocks, is selected. The latter would be advantageous in a situation where the number of Turbo decoder iterations is strictly limited and there are several decoded blocks per TTI.

The selecting step can be repeated once per one or more Transmission Timing Intervals, TTI.

The step of decoding can comprise decoding the received bitstream using at least a third algorithm in parallel with the first and the second algorithms, to even further enhance the flexibility of the channel decoding.

At least one of the decoders may use a logarithmic domain maximum a posteriori, Log-MAP, algorithm.

Further, at least one of the decoders may use an approximation of a Turbo decoding algorithm, and such an approximation may be a logarithmic maximum, Log-Max, approximation of a logarithmic domain maximum a posteriori, Log-MAP, algorithm.

Another possibility for such an approximation is a logarithmic maximum, Log-Max, approximation of a logarithmic domain maximum a posteriori, Log-MAP, algorithm plus a predetermined number of correction terms.

These correction terms may be in linear units, in which case a so called linear logarithmic (Lin-Log) decoder is achieved.

Thus, one or more different approximate decoders may be run in parallel with one or more approximate decoders or with a decoder using a Log-Map algorithm.

According to another aspect of the invention, a receiver for processing a received Turbo encoded bitstream in a communication system is disclosed. The receiver comprises a first channel decoder which is arranged to use a first Turbo decoding algorithm to produce a first decoded bitstream and a first error measure, and a second channel decoder which is arranged to use a second Turbo decoding algorithm to produce a second decoded bitstream and a second error measure. The decoders are operable in parallel, and the receiver further comprises a selector which is arranged to select, for further processing in the receiver, the decoded bitstream and the error measure from the decoder which has the most favorable error measure.

The receiver can be arranged to determine the first error measure on basis of the number of error indicating CRC flags of the first decoded bitstream and the second output error measure on basis of the number of error indicating CRC flags of the second decoded bitstream. The selector can be arranged to select the most favorable error measure as the error measure corresponding to the smallest number of error indicating CRC flags.

The selector can be arranged to select the output and error measure once per one or more Transmission Timing Intervals, TTIs, or block of data.

The receiver can further comprise at least a third decoder which is arranged to use a third algorithm to decode the bitstream in parallel with the first and the second decoder, in order to further enhance the flexibility and performance of the receiver.

At least one of the decoders can be arranged to use a logarithmic domain maximum a posteriori, Log-MAP, algorithm.

At least one of the decoders can be arranged to use an approximate Turbo decoding algorithm.

Specifically, at least one of said decoders can be arranged to use a logarithmic maximum, Log-Max, approximation of a logarithmic domain maximum a posteriori, Log-MAP, algorithm.

At least one of said decoders is arranged to use a logarithmic maximum, Log-Max, approximation of a logarithmic domain maximum a posteriori, Log-MAP, algorithm plus a predetermined number of correction terms. These correction terms can be linear.

The receiver can be incorporated in a wireless communications device or a base station for wireless communication.

Embodiments of the invention will now be described more in detail in connection with the enclosed drawings.

Brief description of the drawings

Fig. 1A schematically shows a communication system,
Fig. 1B schematically shows a Turbo encoding and decoding arrangement,
Fig 2 schematically shows a transmitter and receiver arrangement,
Fig 3 schematically shows part of a receiver according to an embodiment of the invention, and
Fig. 4 schematically illustrates a method according to an embodiment of the invention.

Detailed description of embodiments of the invention

To facilitate an understanding of exemplifying embodiments, many aspects are described in terms of sequences of actions that can be performed by elements of a computer system. For example, it will be recognized that in each of the embodiments, the various actions can be performed by specialized circuits or circuitry (e.g., discrete logic gates interconnected to perform a specialized function), by program instructions being executed by one or more processors, or by a combination of both.

In Fig. 2 a transmitter 201 is shown, which, via a transmitter antenna 202, transmits a signal. A receiver 203 receives the signal via a receiver antenna 204. In the receiver 203, the signal is first processed by a radio processor or unit 205, then by a baseband processor or unit 206 and then by some additional processor or unit 207. The baseband unit 206 comprises a channel decoding unit 208 which in turn comprises at least two channel decoders (not shown in Fig. 2) implementing a Turbo decoding algorithm, which may be either the theoretically optimal one, Log-MAP, or an approximation thereof, according to embodiments of the invention.

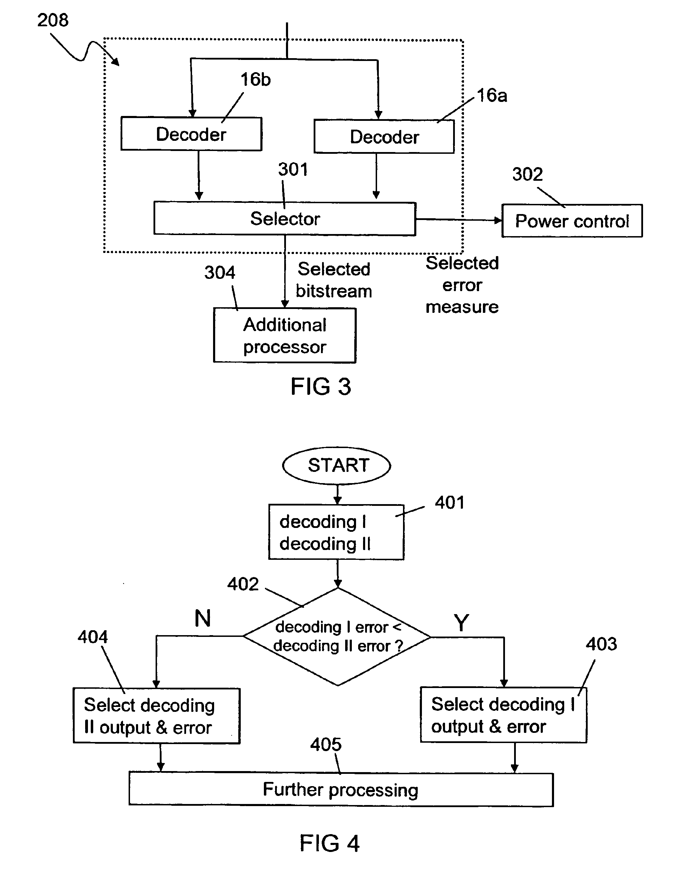

A channel decoding unit 208 according to an embodiment of the invention is shown in Fig. 3. The received signal, which is in the form of an encoded bitstream, comprising blocks of information as well as the extra bits which were mentioned earlier in connection with Fig. 1B, is input to the channel decoding unit. The extra bits include Cyclic Redundancy Check (CRC) bits. They are used by the Turbo decoder to perform a Cyclic Redundancy Check, shortly denoted CRC check. The result of this check is a CRC flag for each coding block. This CRC flag is normally set to 1 for a correctly decoded block and 0 for an incorrectly decoded block. Each Transmission Timing Interval (TTI), comprises one or more such coded blocks.

The encoded bitstream is input to two decoders 16a and 16b in parallel.

Each decoder 16a and 16b implements a different approximate or non approximate Turbo decoding algorithm. In this context it may be noted that the term Turbo decoding algorithm is used for both approximate and non approximate algorithms. Each decoder works in the same way as a standard one. This parallel decoding addresses the problem of having to choose a single decoder a priori which should work for all different conditions.

The output from each of the decoders 16a, 16b corresponds to the output vector $L^i_2$, as described in relation to Fig. 1B. The outputs in the form of decoded bitstreams from each of the decoders are input together with the error measures, such as in the form of CRC flags, to a selector 301. The selector 301 compares the error measures for the decoders, which in this embodiment corresponds to the number of CRC flags indicating errors, and selects the decoder with the smallest amount of error indicating CRC flags. The error measures may correspond to the CRC flag for each coded block, or a mean or filtered CRC flag for one or more TTI:s or a mean or filtered CRC flag for a number of Turbo decoder iterations.

The comparison and selection may advantageously be done once each TTI (Transmission Time Interval), or once per a predefined number of TTI:s, but it is also possible to do it more often, such as once per coded block length if there are more than one coded block per TTI. The CRC flags of the selected decoder are output for further use in the outer loop power control 302.

The decoded bitstream from the selected decoder is then output to an additional processor 304 and to higher layer processing in the receiver. The bitstream and the CRC flags from the non selected decoder are discarded.

In other words, instead of outputting the CRC flags and the decoded bit stream directly after decoding, a new block, in form of the selector 301, which may be implemented in hardware or in software, or a combination thereof, is added to the receiver. The selector 301 compares error measures, which are based on the number of error indicating CRC flags, and selects the decoder with the least errors, and then only outputs the selected decoder's CRC flags for power control etc, and the selected decoder's decoded bit stream for processing in the higher layers.

Regarding the Turbo decoding algorithms used, it may be noted that in addition to the previously discussed Log-MAP decoder and Log-Max decoder, a Log-Max decoder with a number of correction terms can be used. Such a decoder with linear correction terms is denoted Log-Lin (logarithmic linear) and may be used in order to reduce losses for good transmission conditions, and to optimize performance for less good transmission conditions.

As is known in the art, the calculation of the a posteriori probability, i.e. the extrinsic information in the MAP algorithm in the logarithmic domain, uses a soft combining operation COM(x,y), between two values x and y. The operation is defined as

$$\text{COM}(x,y) \equiv \max(x,y) + \log(1 + e^{-|x-y|})$$

In the approximate Turbo decoding algorithms, approximations of the COM(x,y) operation are used. In the Log-Lin decoder the COM(x,y) operation is approximated as

$$\text{COM}(x,y) \approx \max(x,y) + \max\left(\text{floor}(\frac{com2corr - |x-y|}{wi}),0\right),$$

wherein the floor operator rounds the variable off towards the closest lower integer, wi is an integer value chosen appropriately (4 is a common choice) and *com2corr* (also known as correlation length) is chosen depending on the application.

The usual way of choosing the parameters for a decoder is to run the decoder with various numbers of linear correction terms of different magnitudes, for different transport scenarios, to obtain a set of parameters which on average give the best results for the tested cases. For any one of the decoders in the parallel decoder arrangement according to the discussed embodiment of the invention the choice could be *com2corr*=4 for a decoder with only one correction term, i.e. $\max\left(\text{floor}(\frac{com2corr - |x-y|}{4}),0\right) = 1$, when |x-y|=0. For another decoder, com2corr=8 may be used with more correction terms, namely $\max\left(\text{floor}(\frac{com2corr - |x-y|}{4}),0\right) = 2$, when |x-y|=0, and

$\max\left(\text{floor}(\frac{com2corr - |x-y|}{4}),0\right) = 1$ when 0<|x-y| 4. Using com2corr<4 gives the most simple Log-Lin decoder which is known as the Log-Max decoder.

In the embodiment of the invention shown in Fig. 3, the first decoder 16a may for instance be a Log-Lin decoder with correlation length com2corr=4 and the second decoder 204 a Log-Max decoder. As will be understood other possible combinations of the described and other decoders may be used.

In any case, when choosing one single decoder based on results from tested scenarios, the chosen decoder may perform well for a large part of the tested scenarios, but it will hardly have the best performance for all the tested scenarios. Further, the possibility exists that there are other cases which have not been tested. Therefore, embodiments of the invention are advantageous in that at least two decoders are used in parallel, which gives the possibility of adapting to more scenarios. That is, one does not have to choose one single decoder a priori.

Further, the choice between the decoder outputs is made after decoding, which means that there is no need for making a possibly uncertain estimate of the type of transport scenario and choosing the decoder based on statistical data regarding what decoder would perform best for that estimated scenario.

As regards the cooperation between the respective decoders and the selector, a number of different options exist. As a first alternative, a CRC check is performed after each iteration of the respective Turbo decoders. In that case the CRC check can be used to stop the decoding when either of the parallel decoders shows a CRC flag indicating no error, i.e. a correct block. This may save both processing power and time.

As a second alternative, the CRC check is performed after a predefined number of iterations for the Turbo decoders, and then the result from the decoder showing a CRC flag indicating no error, is chosen by the selector.

If both decoders - or in a situation where there are more than two decoders in parallel, at least two of the decoders - have CRC flags indicating no error, any one of the decoder outputs with CRC flags indicating no error may be chosen by the selector.

If, on the other hand, there is no output with a CRC flag indicating no error, more iterations may be performed, or as an alternative, the output from the decoder which gave the best result for the past coding block(s) is chosen.

In Fig. 4 a method according to an embodiment of the invention is illustrated. After a step 401 of two decoders 16a and 16b running in parallel (decoding I and II), a choice 402 is made based upon the error measures from decoding I and II. If the error measure of decoding I is less than the error measure of decoding II, the output from decoding I, step 403, is used for further processing, step 405, i.e. higher layer processing or other additional processing and power control for the outer loop, in the receiver. If, on the other hand, the error measure from decoding I is larger than the error measure from decoding II, step 404, the output from decoding II is used for further processing, step 405, in the receiver. The parallel decoding is run constantly, and as mentioned above, the selection between the outputs can be done once per TTI or once per block of data, or at any other chosen interval.

In Fig. 3 there are only two decoders shown, but more decoders can certainly be used. It would also be possible to use any other approximations of the MAP algorithm. Further, the structure is fully scalable, which means that, i.e., a Log-MAP decoder, implemented as the Log-Max decoder plus a number of correction terms desirable for good channel conditions, may be arranged in parallel with a Log-Max and a Log-Lin decoder. In a high-end product, the receiver may comprise several parallel Log-MAP decoders implemented as the Log-Max decoder plus different numbers of correction terms desirable for different typical channel conditions.

The receiver may be used in a wireless communication device, such as a mobile telephone, pager, etc. or a base station.

Thus, the embodiments disclosed herein are merely illustrative and should not be considered restrictive in anyway. The scope of the invention is given by the appended claims, rather than the preceding description, and all variations and equivalents which fall within the range of the claims are intended to be embraced therein.

**Claims**

1. A method for Turbo decoding a received Turbo encoded bitstream in a communication system, the method comprising the steps of

   • decoding (401) the received bitstream using a first Turbo decoding algorithm to produce a first decoded bitstream and a first error measure, in parallel with decoding (401) the received bitstream using a second Turbo decoding algorithm, which is different from the first decoding algorithm, for producing a second decoded bitstream and a second error measure,
   • selecting (402, 403, 404), for further processing in a receiver (203), the decoded bitstream and error measure from the decoding algorithm which produces the most favorable error measure,

   wherein, in the decoding step (401), the first error measure is determined on basis of a number of error indicating Cyclic Redundancy Check flags associated with the first decoded bitstream and the second error measure is determined on basis of a number of error indicating Cyclic Redundancy Check flags associated with the second decoded bitstream, and wherein, in the selecting step (402, 403, 404), the most favorable error measure is chosen as the error measure corresponding to the smallest number of error indicating Cyclic Redundancy Check flags.

2. The method according to claim 1, wherein the selecting step is performed once per one or more Transmission Timing Intervals, TTIs, or block of data.

3. The method according to any of the preceding claims, wherein the step of decoding comprises decoding the received bitstream using at least a third Turbo decoding algorithm in parallel with the first and the second algorithms.

4. The method according to any of the preceding claims, wherein, in the decoding step (401), at least one of the algorithms is a logarithmic domain maximum a posteriori, Log-MAP, algorithm.

5. The method according to any of the preceding claims, wherein, in the decoding step (401), at least one of the algorithms is an approximate Turbo decoding algorithm.

6. The method according to claim 5, wherein, in the decoding step (401), at least one of the algorithms is a logarithmic maximum, Log-Max, approximation of a logarithmic domain maximum a posteriori, Log-MAP, algorithm.

7. The method according to claim 5 or 6, wherein, in the decoding step (401), at least one of the algorithms is a logarithmic maximum, Log-Max, approximation of a logarithmic domain maximum a posteriori, Log-MAP, algorithm plus a predetermined number of correction terms.

8. The method according to claim 7, wherein the correction terms are linear.

9. A receiver (203) comprising a channel decoding unit (208) for Turbo decoding a received Turbo encoded bitstream in a communication system, wherein the channel decoding unit (208) comprises:

    • a first channel decoder (16a) which is arranged to use a first Turbo decoding algorithm to produce a first decoded bitstream and a first error measure, and
    • a second channel decoder (16b) which is arranged to use a second Turbo decoding algorithm, which is different from the first Turbo decoding algorithm, to produce a second decoded bitstream and a second error measure,

wherein the decoders (16a, 16b) are operated in parallel, and wherein the decoding unit (208) further comprises a selector (301) which is arranged to select, for further processing in the receiver (203), the decoded bitstream and the error measure from the decoder (16a; 16b) which has the most favorable error measure,wherein the receiver (203) is arranged to determine the first error measure on basis of a number of error indicating Cyclic Redundancy Check flags associated with the first decoded bitstream and the second error measure on basis of a number of error indicating Cyclic Redundancy Check flags associated with the second decoded bitstream, and wherein the selector (301) is arranged to select the most favorable error measure as the error measure corresponding to the smallest number of error indicating Cyclic Redundancy Check flags.

10. The receiver according to claim 9, wherein the selector (301) is arranged to select the output and error measure once per one or more Transmission Timing Intervals, TTIs, or block of data.

11. The receiver according to any of claims 9-10, further comprising at least a third decoder which is arranged to use a third Turbo decoding algorithm to decode the bitstream in parallel with the first and the second decoders (16a, 16b).

12. The receiver according to any of claims 9-11, wherein at least one of the decoders (16a, 16b) is arranged to use a logarithmic domain maximum a posteriori, Log-MAP, algorithm.

13. The receiver according to any of claims 9-12, wherein at least one of the decoders (16a, 16b) is arranged to use an approximate Turbo decoding algorithm.

14. The receiver according to claim 13, wherein at least one of said decoders (16a, 16b) is arranged to use a logarithmic maximum, Log-Max, approximation of a logarithmic domain maximum a posteriori, Log-MAP, algorithm.

15. The receiver according to claim 13 or 14, wherein at least one of said decoders (16a, 16b) is arranged to use a logarithmic maximum, Log-Max, approximation of a logarithmic domain maximum a posteriori, Log-MAP, algorithm plus a predetermined number of correction terms.

16. The receiver according to claim 15, wherein the correction terms are linear.

17. A mobile communications device comprising a receiver according to any of claims 9-16.


**Patentansprüche**

1. Verfahren zum Turbo-Dekodieren eines empfangenen Turbo-kodierten Bitstromes in einem Kommunikationssystem, wobei das Verfahren die Schritte umfasst:

    Dekodieren (401) des empfangenen Bitstromes unter Verwendung eines ersten Turbo-Dekodieralgorithmus zur Erzeugung eines ersten dekodierten Bitstromes und eines ersten Fehlergrößenwertes, parallel mit einem Dekodieren (401) des empfangenen Bitstromes unter Verwendung eines zweiten Turbo-Dekodieralgorithmus, der sich von dem ersten Turbo-Dekodieralgorithmus unterscheidet, zum Erzeugen eines zweiten dekodierten Bitstromes und eines zweiten Fehlergrößenwertes,
    Auswählen (402, 403, 404), für eine weitere Verarbeitung in einem Empfänger (203), des dekodierten Bitstromes und Fehlergrößenwertes aus dem Dekodieralgorithmus, der den günstigsten Fehlergrößenwert erzeugt, wobei in dem Dekodierschritt (401) der erste Fehlergrößenwert auf Grundlage einer Anzahl von Fehler-anzeigenden zyklischen Redundanzüberprüfungsflags bzw. Cyclic Redundancy Check Flags bestimmt wird, die mit dem ersten dekodierten Bitstrom verbunden sind, und wobei in dem Auswahlschritt (402, 403, 404) der günstigste Fehlergrößenwert als der Fehlergrößenwert gewählt wird, der mit der kleinsten Anzahl von Fehler-anzeigenden zyklischen Redundanzüberprüfungsflags bzw. Cyclic Redundancy Check Flags zusammenhängt.

2. Verfahren nach Anspruch 1, wobei der Auswahlschritt einmal während eines oder mehrerer Übertragungszeitintervalls, TTIs, oder Datenblöcke durchgeführt wird.

3. Verfahren nach irgendeinem der vorhergehenden Ansprüche, wobei der Schritt zum Dekodieren ein Dekodieren des empfangenen Bitstromes unter Verwendung zumindest eines dritten Turbo-Dekodieralgorithmus parallel zu dem ersten und dem zweiten Turbo-Dekodieralgorithmus umfasst.

4. Verfahren nach irgendeinem der vorherigen Ansprüche, wobei in dem Dekodierschritt (401) zumindest einer der Algorithmen ein logarithmischer Domain-Maximum a posteriori, Log-MAP, Algorithmus ist.

5. Verfahren nach irgendeinem der vorherigen Ansprüche, wobei in dem Dekodierschritt (401) zumindest einer der Algorithmen ein approximativer Turbo-Dekodieralgorithmus ist.

6. Verfahren nach Anspruch 5, wobei in dem Dekodierschritt (401) zumindest einer der Algorithmen eine logarithmische Maximum-, Log-MAP, Approximierung eines logarithmischen Domain-Maximum a posteriori, Log-MAP, Algorithmus ist.

7. Verfahren nach Anspruch 5 oder 6, wobei in dem Dekodierschritt (401) zumindest einer der Algorithmen eine logarithmische Maximum-, Log-MAP, Approximierung eines logarithmischen Domain-Maximum a posteriori, Log-MAP, Algorithmus zuzüglich einer vorbestimmten Anzahl von Korrekturausdrücken ist.

8. Verfahren nach Anspruch 7, wobei die Korrekturausdrücke linear sind.

9. Empfänger (203) mit einer Kanaldekodiereinheit (208) zum Turbo-Dekodieren eines empfangenen Turbo-kodierten Bitstromes in einem Kommunikationssystem, wobei die Kanaldekodiereinheit (208) umfasst:

eine erste Kanaldekodiereinheit (16a), die ausgelegt ist, einen ersten Turbo-Dekodieralgorithmus zu verwenden, um einen ersten dekodierten Bitstrom und einen ersten Fehlergrößenwert zu erzeugen, und
eine zweite Kanaldekodiereinheit (16b), die ausgelegt ist, einen zweiten Turbo-Dekodieralgorithmus zu verwenden, der sich von dem ersten Turbo-Dekodieralgorithmus unterscheidet, um einen zweiten dekodierten Bitstrom und einen zweiten Fehlergrößenwert zu erzeugen,
wobei die Dekodiereinheiten (16a, 16b) parallel betrieben werden, und wobei die Dekodiereinheit (208) ferner eine Auswahleinheit (301) umfasst, die bei der weiteren Verarbeitung in dem Empfänger (203) ausgelegt ist, den dekodierten Bitstrom und den Fehlergrößenwert von der Dekodiereinheit (16a, 16b) auszuwählen, der den günstigsten Fehlergrößenwert aufweist, wobei der Empfänger (203) ausgelegt ist zum Bestimmen des ersten Fehlergrößenwerts auf Grundlage einer Anzahl von, mit dem ersten dekodierten Bitstrom verbundener Fehler-anzeigenden zyklischen Redundanzüberprüfungsflags bzw. Cyclic Redundancy Check Flags und des zweiten Fehlergrößenwerts auf Grundlage einer Anzahl von, mit dem zweiten dekodierten Bitstrom verbundener Fehler-anzeigenden zyklischen Redundanzüberprüfungsflags bzw. Cyclic Redundancy Check Flags, und wobei die Auswahleinheit (301) ausgelegt ist, den günstigsten Fehlergrößenwert als den Fehlergrößenwert auszuwählen, der mit der kleinsten Anzahl von Fehler-anzeigenden zyklischen Redundanzüberprüfungsflags bzw. Cyclic Redundancy Check Flags zusammenhängt.

10. Empfänger nach Anspruch 9, wobei die Auswahleinheit (301) ausgelegt ist, die Ausgabe und Fehlergrößenwert einmal während eines oder mehrerer Übertragungszeitintervalls, TTIs, oder Datenblöcke auszuwählen.

11. Empfänger nach irgendeinem der Ansprüche 9-10, ferner mit zumindest einer dritten Dekodiereinheit, die ausgelegt ist, einen dritten Turbo-Dekodieralgorithmus zu verwenden, um den Bitstrom parallel mit der ersten und der zweiten Dekodiereinheit (16a, 16b) zu dekodieren.

12. Empfänger nach irgendeinem der Ansprüche 9-11, wobei zumindest einer der Dekodiereinheiten (16a, 16b) ausgelegt ist, einen logarithmischen Domain-Maximum a posteriori, Log-MAP, Algorithmus zu verwenden.

**13.** Empfänger nach irgendeinem der Ansprüche 9-12, wobei zumindest einer der Dekodiereinheiten (16a, 16b) ausgelegt ist, einen approximativen Turbo-Dekodieralgorithmus zu verwenden.

**14.** Empfänger nach Anspruch 13, wobei zumindest einer der Dekodiereinheiten (16a, 16b) ausgelegt ist, eine logarithmische Maximum-, Log-MAP, Approximierung eines logarithmischer Domain-Maximum a posteriori, Log-MAP, Algorithmus zu verwenden.

**15.** Empfänger nach Anspruch 13 oder 14, wobei zumindest einer der Dekodiereinheiten (16a, 16b) ausgelegt ist, eine logarithmische Maximum-, Log-MAP, Approximierung eines logarithmischer Domain-Maximum a posteriori, Log-MAP, Algorithmus zuzüglich einer vorbestimmten Anzahl von Korrekturausdrücken zu verwenden.

**16.** Empfänger nach Anspruch 15, wobei die Korrekturterme linear sind.

**17.** Mobilkommunikationsvorrichtung mit einem Empfänger nach irgendeinem der Ansprüche 9-16.

**Revendications**

**1.** Procédé de turbodécodage d'un flux binaire turbocodé reçu dans un système de communication, le procédé comprenant les étapes qui consistent

• à décoder (401) le flux binaire reçu en utilisant un premier algorithme de turbodécodage pour produire un premier flux binaire décodé et une première mesure d'erreur, en parallèle avec le décodage (401) du flux binaire reçu en utilisant un second algorithme de turbodécodage, qui est différent du premier algorithme de décodage, pour produire un second flux binaire décodé et une seconde mesure d'erreur,
• à sélectionner (402, 403, 404), pour un traitement supplémentaire dans un récepteur (203), le flux binaire décodé et la mesure d'erreur provenant de l'algorithme de décodage qui produit la mesure d'erreur la plus favorable,

dans lequel, dans l'étape de décalage (401), la première mesure d'erreur est déterminée sur la base d'un nombre de drapeaux de Contrôle de Redondance Cyclique indiquant des erreurs, associés au premier flux binaire décodé et la seconde mesure d'erreur est déterminée sur la base d'un nombre de drapeaux de Contrôle de Redondance Cyclique indiquant des erreurs associés au second flux binaire décodé, et dans lequel, dans l'étape de sélection (402, 403 et 404), la mesure d'erreur la plus favorable est choisie en tant que mesure d'erreur correspondant au plus petit nombre de drapeaux de Contrôle de Redondance Cyclique indiquant des erreurs.

**2.** Procédé selon la revendication 1, dans lequel l'étape de sélection est exécutée une fois pour un ou plusieurs Intervalles de Temps d'Emission, TTI, ou pour un bloc de données.

**3.** Procédé selon l'une quelconque des revendications précédentes, dans lequel l'étape de décodage comprend le décodage du flux binaire reçu en utilisant au moins un troisième algorithme de turbodécodage en parallèle avec les premier et deuxième algorithmes.

**4.** Procédé selon l'une quelconque des revendications précédentes, dans lequel, dans l'étape de décodage (401), au moins l'un des algorithmes est un algorithme de maximum a posteriori de domaine logarithmique, Log-MAP.

**5.** Procédé selon l'une quelconque des revendications précédentes, dans lequel, dans l'étape de décodage (401), au moins l'un des algorithmes est un algorithme de turbodécodage approximé.

**6.** Procédé selon la revendication 5, dans lequel, dans l'étape de décodage (401), au moins l'un des algorithmes est une approximation de maximum logarithmique, Log-Max, d'un algorithme de maximum a posteriori de domaine logarithmique, Log-MAP.

**7.** Procédé selon la revendication 5 ou 6, dans lequel, dans l'étape de décodage (401), au moins l'un des algorithmes est une approximation de maximum logarithmique, Log-Max, d'un algorithme de maximum a posteriori de domaine logarithmique, Log-MAP, plus un nombre prédéterminé de termes de correction.

**8.** Procédé selon la revendication 7, dans lequel les termes de correction sont linéaires.

**9.** Récepteur (203) comportant une unité de décodage (208) de canaux pour le turbodécodage d'un flux binaire turbocodé reçu dans un système de communication, dans lequel l'unité (208) de décodage de canaux comporte :

• un premier décodeur de canal (16a) qui est agencé pour utiliser un premier algorithme de turbodécodage afin de produire un premier flux binaire décodé et une première mesure d'erreur, et
• un second décodeur de canal (16b) qui est agencé pour utiliser un second algorithme de turbodécodage, qui est différent du premier algorithme de turbodécodage, afin de produire un second flux binaire décodé et une seconde mesure d'erreur,

dans lequel les décodeurs (16a, 16b) sont mis en oeuvre en parallèle, et dans lequel l'unité de décodage (208) comporte en outre un sélecteur (301) qui est agencé pour sélectionner, pour un traitement supplémentaire dans le récepteur (203), le flux binaire décodé et la mesure d'erreur provenant du décodeur (16a ; 16b) qui a la mesure d'erreur la plus favorable, dans lequel le récepteur (203) est agencé pour déterminer la première mesure d'erreur sur la base d'un nombre de drapeaux de Contrôle de Redondance Cyclique indiquant des erreurs associés au premier flux binaire décodé et à la seconde mesure d'erreur sur la base d'un nombre de drapeaux de Contrôle de Redondance Cyclique indiquant des erreurs associés au second flux binaire décodé, et dans lequel le sélecteur (301) est agencé pour sélectionner la mesure d'erreur la plus favorable en tant que mesure d'erreur correspondant au plus petit nombre de drapeaux de Contrôle de Redondance Cyclique indiquant des erreurs.

**10.** Récepteur selon la revendication 9, dans lequel le sélecteur (301) est agencé pour sélectionner la sortie et la mesure d'erreur une fois pour un ou plusieurs Intervalles de Temps d'Emission, TTI, ou pour un bloc de données.

**11.** Récepteur selon l'une des revendications 9 et 10, comportant en outre au moins un troisième décodeur qui est agencé pour utiliser un troisième algorithme de turbodécodage afin de décoder le flux binaire en parallèle avec les premier et deuxième décodeurs (16a, 16b).

**12.** Récepteur selon l'une des revendications 9 à 11, dans lequel au moins l'un des décodeurs (16a, 16b) est agencé pour utiliser un algorithme de maximum a posteriori de domaine logarithmique, Log-MAP.

**13.** Récepteur selon l'une quelconque des revendications 9 à 12, dans lequel au moins l'un des décodeurs (16a, 16b) est agencé pour utiliser un algorithme de turbodécodage approximé.

**14.** Récepteur selon la revendication 13, dans lequel au moins l'un desdits décodeurs (16a, 16b) est agencé pour utiliser une approximation de maximum logarithme, Log-Max, d'un algorithme de maximum a posteriori de domaine logarithmique, Log-MAP.

**15.** Récepteur selon la revendication 13 ou 14, dans lequel au moins l'un desdits décodeurs (16a, 16b) est agencé pour utiliser une approximation de maximum logarithmique, Log-Max, d'un algorithme de maximum a posteriori de domaine logarithmique, Log-MAP, plus un nombre prédéterminé de termes de correction.

**16.** Récepteur selon la revendication 15, dans lequel les termes de correction sont linéaires.

**17.** Dispositif de communication mobile comportant un récepteur selon l'une quelconque des revendications 9 à 16.

EP 1 821 415 B1

FIG 1A

FIG 2

FIG 1B

208

16b

Decoder

16a

Decoder

301

Selector

302

Power control

304

Selected
bitstream

Selected
error
measure

Additional
processor

FIG 3

START

decoding I
decoding II

401

402

N

decoding I error <
decoding II error ?

Y

404

403

Select decoding
II output & error

Select decoding I
output & error

405

Further processing

FIG 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040151259 A1
- US 20040151259 A
- US 6400731 B
- US 20020404 B

**Non-patent literature cited in the description**

- **C. BERROU ; A. GLAVIEUX.** Near Optimum Error Correcting Coding and Decoding: Turbo-codes. *IEEE Transactions on Communications,* October 1996, vol. 44 (10
- **FOSSORIER M. P. C et al.** Complementary reliability-based decodings of binary linear block codes. *IEEE Transactions on information theory,* September 1997, vol. 43 (5), 1667-1672